# EUROPEAN PATENT APPLICATION

(11) **EP 2 725 626 A1**
(43) Date of publication of application: **30.04.2014**
(21) Application number: 12805080.4
(22) Date of filing: 27.06.2012
(51) Int. Cl.: H01L 31/042

(54) **SOLAR CELL MODULE AND SOLAR CELL MODULE MANUFACTURING METHOD**

(30) Priority: 27.06.2011 JP 2011141986
(71) Applicant: Dexerials Corporation, Tokyo 141-0032 (JP)
(72) Inventor: NISHIMOTO, Masahiro, Tokyo 141-0032 (JP); MORI, Daichi, Tokyo 141-0032 (JP)
(74) Representative: Müller - Hoffmann & Partner
(86) International application number: PCT/JP2012/066338
(87) International publication number: WO 2013/002243

(57) **Abstract**

An objective of the present invention is to improve a terminal box tab wire connection strength and also to avoid warping and breakage of a translucent insulation substrate. A solar cell module is provided with: a solar cell (1) with a cathode (9) and an anode (10) positioned on one surface thereof; a pair of power extraction tab wires (11, 15) which are connected onto the cathode (9) and the anode (10) of the solar cell (1) with a conductive adhesive layer (16) interposed therebetween; and a pair of terminal box tab wires (24) which are disposed on one surface of the solar cell (1) with an insulating adhesive layer (22) interposed therebetween, one end (24a) thereof being positioned on the cathode (9) and the anode (10) and which connect a terminal box (23) with the pair of power extraction tab wires (11, 15), and in this configuration, the power extraction tab wires (11, 15) on the cathode (9) and the anode (10) are connected to the one end (24a) of the terminal box tab wires (24) with the conductive adhesive layer (16) interposed therebetween.

## Description

### Field of the Invention

This invention relates to a solar cell module in which a cathode electrode and an anode electrode are made face to face with each other on one of surfaces and a terminal box tab wire is installed thereon, and in particular concerns a connection between the terminal box tab wire and a collector tab wire for use in electrode extraction.

The present application asserts priority rights based on JP Patent Application 2011-141986 filed in Japan on June 27, 2011. The total contents of disclosure of the Patent Application of the senior filing date are to be incorporated by reference into the present Application.

### Background of the Invention

In recent years, along with a trend in which a reduction in environmental load becomes a global subject, big expectations have been put on the photovoltaic power generation as a clean and reproducible energy. At present, the main trend of solar cells concerns bulk silicon solar cells in which crystals of a single crystal silicon and polycrystal silicon are produced and these are slice-processed to form a plate-shaped semiconductor and this is utilized. In this case, however, the bulk silicon solar cell requires much energy and time so as to grow silicon crystals and complicated processes are also required for its manufacturing processes.

On the other hand, a so-called thin-film solar cell in which a semiconductor layer serving as a photoelectric conversion layer is formed on a substrate such as glass, stainless steel or the like is considered to form the main trend of the solar cells in the future, because of its thinness, light weight, inexpensive manufacturing costs, easiness of manufacturing a large surface area, and the like. Examples of the thin-film solar cell include a thin-film silicon solar cell composed of amorphous silicon and a microcrystal silicon film or a tandem-type of these, and a CIGS-type solar cell or the like in which a compound semiconductor formed by mixing elements, typically represented by Cu (copper), In (indium), Ga (gallium) and Se (serene), is utilized.

These thin-film solar cells are formed through processes in which on an inexpensive substrate with a large area, a semiconductor layer or a metal electrode film is stacked by using a forming device, such as a plasma CVD device or a sputtering device, and thereafter, a photoelectric conversion layer formed on the same substrate is separated and connected by using a laser patterning process or the like so that solar cell strings are formed.

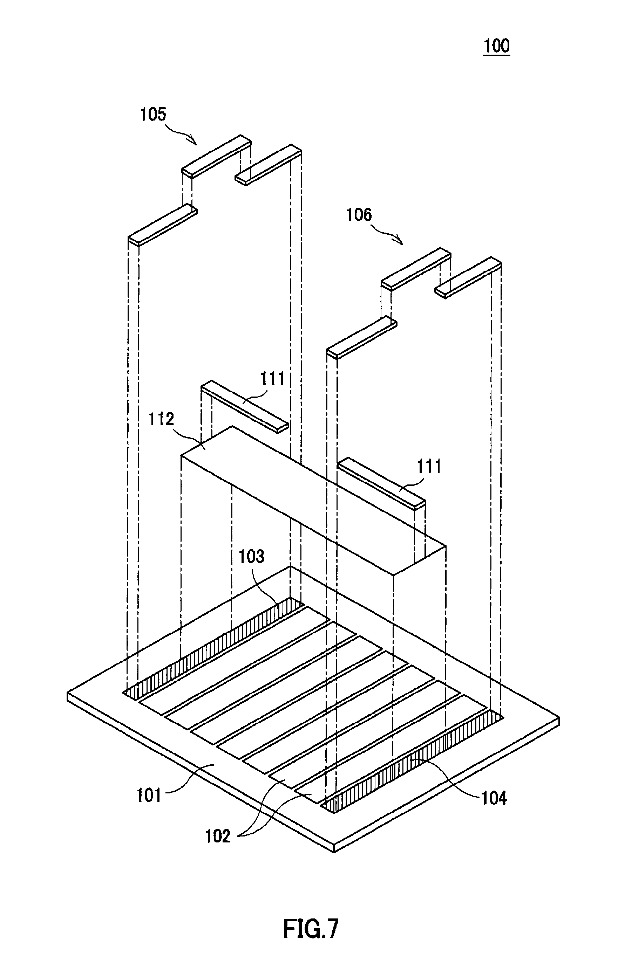

Fig. 7 shows one example of a configuration of a conventional thin-film solar cell in which the solar cell strings are used. This thin-film solar cell 100 is composed of a plurality of solar cells 102 each formed by stacking on a translucent insulating substrate 101 a transparent electrode film made of a transparent conductive film, not shown, a photoelectric conversion layer and a back surface electrode film. Each solar cell 102 has a thin elongated stripe-shape, and has a length that extends over the entire width of the translucent insulating substrate 101. Moreover, the thin-film solar cell 100 is configured such that between mutually adjacent solar cells 102, by connecting a transparent electrode film on one side to a back surface electrode film on the other side so that the plural solar cells 102 are connected in series with one after another.

On an end portion of a transparent electrode film of the solar cell 102 of one end portion in the thin-film solar cell 100, a linear P-type electrode terminal unit 103 having virtually the same length as that of the solar cell 102 is formed, and on an end portion of a back surface electrode film of the solar cell 102 on the other end portion, a linear N-type electrode terminal unit 104 having virtually the same length as that of the solar cell 102 is formed. These P-type electrode terminal unit 103 and N-type electrode terminal unit 104 form electrode extraction units.

With respect to the P-type electrode terminal unit 103, a cathode collector tab wire 105 made of a copper foil is electrically and mechanically joined to the entire surface of the P-type electrode terminal unit 103 referred to as a bus bar. In the same manner, with respect to the N-type electrode terminal unit 104, an anode collector tab wire 106 made of a copper foil is electrically and mechanically joined to the entire surface of the N-type electrode terminal unit 104. As the joining means for these, in general, a soldering process is carried out.

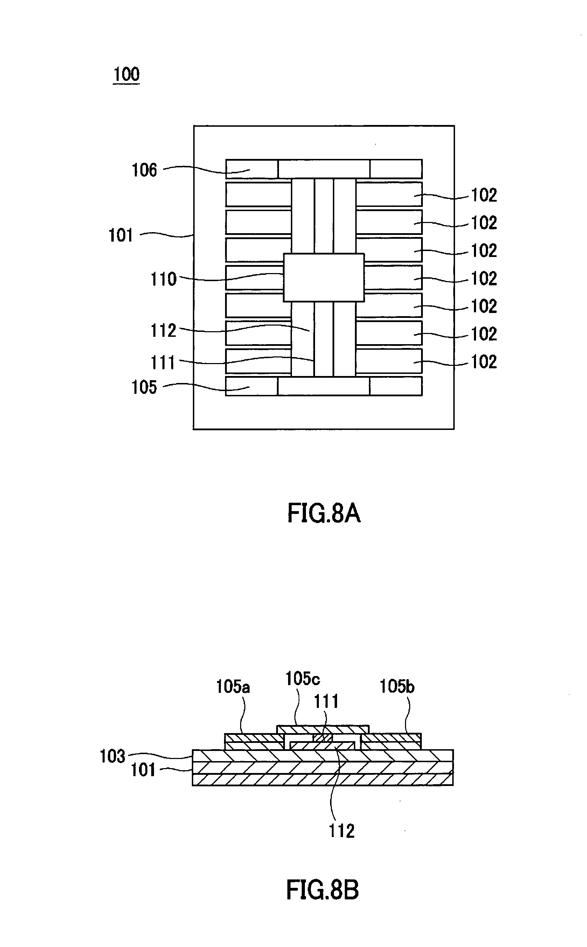

Moreover, as shown in Fig. 8(A), onto the back surface of the thin-film solar cell 100, a terminal box 110 that is connected to the P-type electrode terminal unit 103 and the N-type electrode terminal unit 104 so as to externally output electricity and a terminal box tab wire 111 for connecting this terminal box 110 to the P-type electrode terminal unit 103 and the N-type electrode terminal unit 104 are connected.

The terminal box 110 is secured in the center of the back surface of the thin-film solar cell 100, for example, with an insulating adhesive being interposed therebetween. The terminal box tab wire 111 is made of an elongated copper foil or Al foil in the same manner as in the cathode collector tab wire 105 and the anode collector tab wire 106, and disposed on the back surface of the thin-film solar cell 100 with an insulating tape 112 interposed therebetween.

The terminal box tab wire 111 has its one end solder-connected to the terminal box 110, with the other end being disposed on the P-type electrode terminal unit 103 or the N-type electrode terminal unit 104 with the insulating tape 112 interposed therebetween.

As shown in Fig. 8(B), the connection portion of the terminal box tab wire 111 and the cathode collector tab wire 105 is configured such that a third cathode collector tab wire 105c is connected along a gap between first and second cathode collector tab wires 105c and 105b connected to two sides sandwiching the insulating tape 112 and the terminal box tab wire 111, in a manner so as to bridge over the insulating tape 112 and the terminal box tab wire 111. Moreover, the third cathode collector tab wire 105c is connected to the terminal box tab wire 111. The connections (two portions) between these first and second cathode collector tab wires 105a, 105c and the third cathode collector tab wire 105c and the connection (one portion) between the third cathode collector tab wire 105c and the terminal box tab wire 111 are carried out by ultrasonic solder joining processes. The connection between the anode collector tab wire 106 and the terminal box tab wire 111 is also carried out in the same manner.

### Prior-Art Documents

### Patent Document

PTL 1: Japanese Patent Application Laid-Open No. 2009-295744

### Summary of the Invention

However, the thin-film solar cell 100 is made of various materials, such as Al, Ag, ZnO or the like in accordance with manufacturing methods, configurations or the like of the P-type electrode terminal unit 103 and the N-type electrode terminal unit 104, and depending on the materials, the connection strength relative to the cathode collector tab wire 105 and the anode collector tab wire 106 is not maintained by soldering. For this reason, the connection resistance value tends to increase, resulting in a reduction in power generation efficiency.

Moreover, upon connection among the first and second cathode collector tab wires 105a, 105c and the third cathode collector tab wire 105c and upon connection between the third cathode collector tab wire 105c and the terminal box tab wire 111, since a heat history in a high temperature range caused by the solder connection is locally applied thereto, warping sometimes occurs in the translucent insulating substrate 101 made of glass or the like, causing damages thereto.

Therefore, an object of the present invention is to provide a solar cell module that makes it possible to improve a connection strength of a terminal box tab wire and also to prevent warping and breakage of a translucent insulating substrate and a method of manufacturing such a solar cell module.

In order to solve the above-mentioned problems, a solar cell module in accordance with the present invention is provided with: a solar cell with a cathode and an anode positioned on one surface thereof; a pair of power extraction tab wires which are connected onto the cathode and the anode of the solar cell with a conductive adhesive layer containing conductive particles interposed therebetween; and a pair of terminal box tab wires which are disposed on one surface of the solar cell with an insulating adhesive layer containing no conductive particles interposed therebetween, with one end thereof being positioned on the cathode and the anode, and which connect a terminal box with the pair of power extraction tab wires, and in this configuration, the power extraction tab wires on the cathode and the anode are connected to the one end of the terminal box tab wires with the conductive adhesive layer interposed therebetween.

Moreover, a method of manufacturing a solar cell module in accordance with the present invention is provided with the steps of: preparing a solar cell with a cathode and an anode positioned on one surface thereof; disposing on the one surface of the solar cell a pair of terminal box tab wires with an insulating adhesive layer with no conductive particles contained therein interposed therebetween, as well as disposing end portions of the terminal box tab wires on the cathode and the anode with the insulating adhesive layer interposed therebetween; and connecting a pair of power extraction tab wires onto the cathode and the anode of the solar cell with a conductive adhesive layer containing conductive particles interposed therebetween, as well as connecting the pair of power extraction tab wires to the end portions of the terminal box tab wires on the cathode and the anode, with the conductive adhesive layer interposed therebetween.

### Effects of Invention

In accordance with the present invention, in comparison with a configuration in which a terminal box tab wire is connected onto a power extraction tab wire, it becomes possible to increase a contact area between the terminal box tab wire and the power extraction tab wire with a conductive adhesive layer interposed therebetween, and consequently to improve connection strength, as well as preventing an increase in resistance value.

### Brief Description of Drawings

Figures 1(A) and 1(B) are views showing a solar cell to which the present invention is applied, Figure 1(A) is a perspective view showing a state prior to connection with tab wires, and Figure 1(B) is a plan view showing a state in which the tab wires are connected.
Figure 2 is an exploded perspective view showing a solar cell module.
Figure 3 is a cross-sectional view showing a connection portion between a collector tab-use wire and a terminal box tab wire.
Figure 4 is a cross-sectional view showing a configuration of a conductive adhesive film.
Figure 5 is a cross-sectional view showing the collector-use tab wire to which the conductive adhesive film is bonded.
Figure 6 is a cross-sectional view showing another structural example of an insulating adhesive layer.
Figure 7 is an exploded perspective view showing one example of a conventional thin-film solar cell.
Figures 8(A) and 8(B) are views showing one example of a conventional thin-film solar cell, Figure 8(A) is a plan view and Figure 8(B) is a cross-sectional view showing an electrode terminal unit.

### Detailed Description of the Invention

Referring to Figures, the following description will discuss a solar cell module to which the present invention is applied and a method for manufacturing the solar cell module in detail. Additionally, the present invention is not intended to be limited only by the following embodiments, and it is needless to say that various modifications may be made therein within a scope not departing from the gist of the present invention.

### [Solar Cell Module]

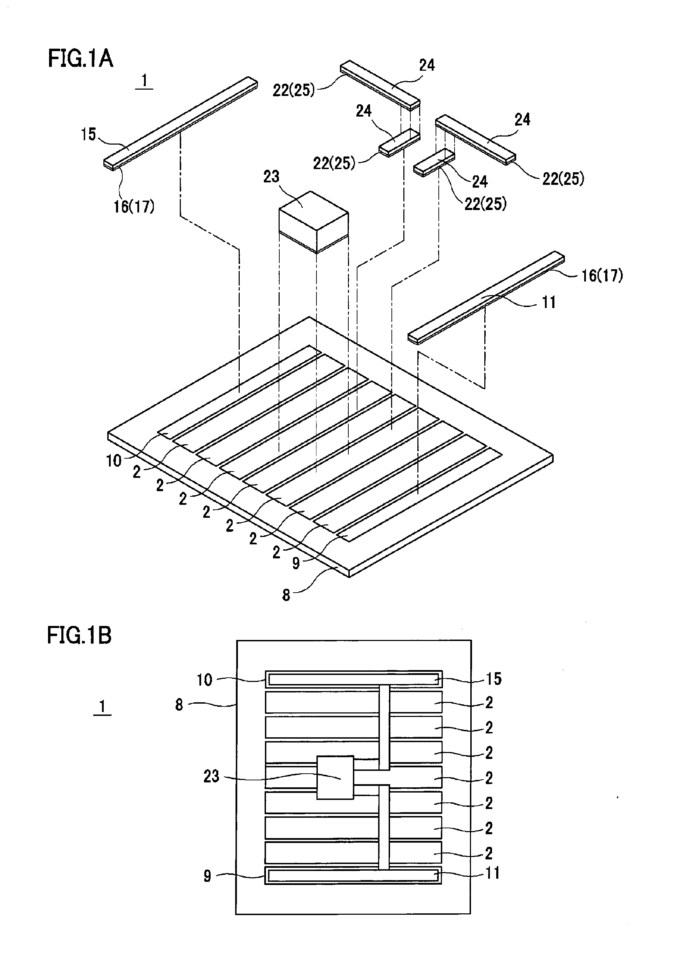

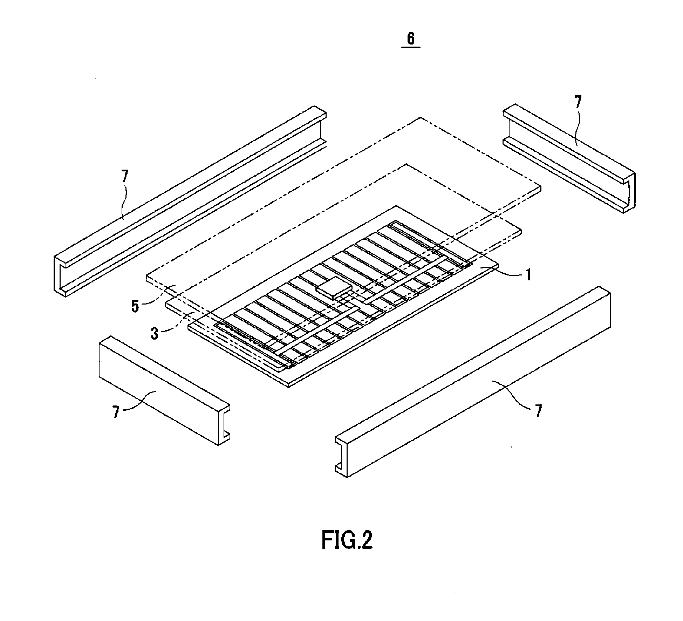

As shown in Figs. 1(A) and 1(B), a thin-film solar cell 1 has a configuration in which a plurality of solar cells 2 are connected to one another by contact lines so that a solar cell string is formed. As shown in Fig. 2, the thin-film solar cell 1 having this string structure, as a single unit or as a matrix composed of a plurality of sheets combined with one another, is subjected to a one-lot laminating process together with a sealing agent sheet 3 and a back sheet 5 formed on the back surface side thereof so that a solar cell module 6 is formed. Additionally, onto a peripheral portion of the solar cell module 6, a metal frame 7 made of aluminum or the like is attached on demand.

As the sealing agent, for example, a translucent sealing material, such as, for example, an ethylene vinyl acetate resin (EVA) or the like, is used. Moreover, as the back sheet 5, a laminate member or the like in which glass or an aluminum foil is sandwiched by resin films is used.

### [Solar Cell]

The thin-film solar cell 1 to which the present invention is applied is a solar cell of a super straight type in which, although not shown in Figs., on a translucent insulating substrate 8, a transparent electrode film made of a transparent conductive film, a photoelectric conversion layer and a back surface electrode film are stacked in this order so that light is made incident on the transparent insulating substrate 8 side. Additionally, the thin-film solar cell also includes a solar cell of a sub-straight type that is formed by stacking a base substrate, a back surface electrode, a photoelectric conversion electrode and a transparent electrode in this order. The following description will be explained by exemplifying the thin-film solar cell 1 of a super straight type; however, the present technique is also applicable to a thin-film solar cell of a sub-straight type.

As the translucent insulating substrate 8, glass or a heat resistant resin, such as polyimide, may be used.

As the transparent electrode film, for example, SnO₂, ZnO, ITO or the like may be used. As the photoelectric conversion layer, a silicon-based photoelectric conversion film, such as amorphous silicon, microcrystal silicon, or polycrystal silicon, and a compound-based photoelectric conversion film, such as CdTe, CuInSe₂, Cu(In, Ga)Se₂ or the like, may be used.

The back surface electrode film has a laminated structure of, for example, a transparent conductive film and a metal film. As the transparent electrode film, SnO₂, ZnO, ITO or the like may be used. As the metal film, silver, aluminum or the like may be used.

The thin-film solar cell 1 configured in this manner has a structure in which, as shown in Fig. 1(A), a plurality of rectangular-shaped solar cells 2 having a length covering virtually the entire width of the translucent insulating substrate 8 are formed. The respective solar cells 2 are separated from one another by an electrode division line, and with respect to the adjacent solar cells 2, the transparent electrode film of one of the cells and the back surface electrode film of the other are mutually connected with each other by a contact line so that a solar cell string with a plurality of solar cells 2 being connected in series with one another is formed.

In the thin-film solar cell 1, a linear P-type electrode terminal unit 9 having virtually the same length as that of the solar cell 2 is formed on one end of the transparent electrode film of the solar cell 2 located on one end of the solar cell string, and a linear N-type electrode terminal unit 10 having virtually the same length as that of the solar cell 2 is formed on an end of the back surface electrode film on the other end of the solar cell 2. With these P-type electrode terminal unit 9 and N-type electrode terminal unit 10 serving as an electrode extraction unit, the thin-film solar cell 1 supplies electricity to a terminal box 23 through a cathode collector tab wire 11 and an anode collector tab wire 15.

### [Collector Tab Wire]

Each of the cathode collector tab wire 11 and the anode collector tab wire 15 is prepared as a flat rectangular-shaped line with a width of 1 to 3 mm that is virtually the same width as that of the P-type electrode terminal unit 9 and the N-type electrode terminal unit 10, by slitting a copper foil or an aluminum foil rolled into, for example, a thickness of 50 to 300µm, or by rolling thin metal wires of copper, aluminum or the like into a flat plate shape.

The cathode collector tab wire 11 is electrically and mechanically joined to the P-type electrode terminal unit 9 through a conductive adhesive layer 16, and the anode collector tab wire 15 is electrically and mechanically joined to the N-type electrode terminal unit 10 through the conductive adhesive layer 16.

### [Conductive Adhesive Layer]

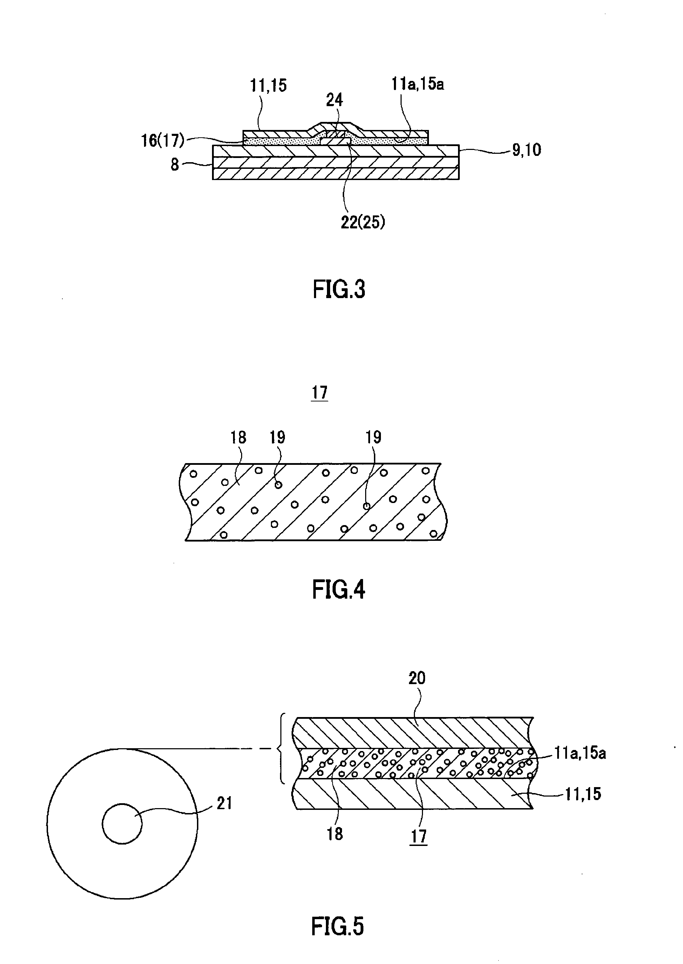

As shown in Fig. 3, the conductive adhesive layer 16 is formed on each of the surfaces 11a and 15a of the cathode collector tab wire 11 and the anode collector tab wire 15. The conductive adhesive layer 16 is formed over the entire surface of each of the surfaces 11a and 15a of the cathode collector tab wire 11 and the anode collector tab wire 15, and made of, for example, a conductive adhesive film 17.

As shown in Fig. 4, the conductive adhesive film 17 is formed by allowing a thermo-setting binder resin layer 18 to contain conductive particles 19 at high density. Moreover, from the viewpoint of indenting property, the conductive adhesive film 17 is preferably designed to have the lowest melt viscosity of the binder resin in a range from 100 to 100000 Pa·s. When the lowest melt viscosity of the conductive adhesive film 17 is too low, the resin tends to flow from a low press-bonding process to a main curing process to easily cause any connection failure or any protrusion onto the cell light-receiving surface, resulting in a reduction in light receiving rate. Moreover, when the lowest melt viscosity is too high, a failure tends to occur upon pasting the film, resulting in any adverse effect to connection reliability. Additionally, the lowest melt viscosity can be measured by loading a predetermined amount of a sample to a rotary viscometer and measuring the viscosity while raising the temperature at a predetermined rate.

Although not particularly limited, as the conductive particles 19 used for the conductive adhesive film 17, examples thereof include: metal particles such as nickel, gold, silver and copper, resin particles to which gold plating or the like is applied and resin particles that are subjected to gold plating or the like on the outermost layers thereof.

The conductive particles may be powder with the particles being individually contained therein; however, the conductive particles are preferably prepared as chain-shaped particles in which primary particles are coupled to one after another. The example of the former includes spherical nickel powder with spike-shaped protrusions, and the example of the latter that is more preferably used includes filament-shaped nickel powder. By using the latter, the conductive particles 19 are allowed to have elasticity so that the connection reliability between the cathode collector tab wire 11 and P-type electrode terminal unit 9 having mutually different physical properties and the connection reliability between the anode collector tab wire 15 and the N-type electrode terminal unit 10 can be improved respectively.

Additionally, the conductive adhesive film 17 preferably has a viscosity in a range from 10 to 10000 kPa·s, more preferably, from 10 to 5000 kPa·s, at about normal temperature. By setting the viscosity of the conductive adhesive film 17 in the range from 10 to 10000 kPa·s, it becomes possible to prevent blocking due to so-called protrusion in the case when the conductive adhesive film 17 is formed on one surface 11a, 15a of the cathode collector tab wire 11 or the anode collector tab wire 15 and wound around a reel 21, and also to maintain a predetermined tacking strength.

Although not particularly limited as long as the above-mentioned characteristics are not impaired, the composition of the binder resin layer 18 of the conductive adhesive film 17 preferably includes a film-forming resin, a liquid-state epoxy resin, a potential curing agent and a silane coupling agent.

The film-forming resin corresponds to a high-molecular-weight resin having an average molecular weight of 10000 or more, and from the viewpoint of a film forming characteristic, preferably, the average molecular weight thereof is set to about 10000 to 80000. As the film-forming resin, various resins, such as an epoxy resin, a modified epoxy resin, a urethane resin, a phenoxy resin and the like, may be used, and among these, from the viewpoint of film-forming state, connection reliability, etc., the phenoxy resin is preferably used.

As the liquid-state epoxy resin, not particularly limited as long as it has flowability at normal temperature, any commercially-available epoxy resin may be used. Specific examples of these epoxy resins include: naphthalene-type epoxy resins, biphenyl-type epoxy resins, phenol novolak-type epoxy resins, bisphenol-type epoxy resins, stilbene-type epoxy resins, triphenol methane-type epoxy resins, phenol aralkyl-type epoxy resins, naphthol-type epoxy resins, dicyclopentadiene-type epoxy resins and triphenyl methane-type epoxy resins. One of these may be used alone, or two kinds or more of these may be used in combination. Moreover, another organic resin, such as an acrylic resin, may be used in combination on demand.

As the potential curing agent, various curing agents, such as a hot setting-type, UV-setting-type or the like curing agent, may be used. The potential curing agent is not allowed to react normally, but is activated with a certain trigger, and starts a reaction. As the trigger, heat, light, pressure or the like is used, and by making selection among these depending on the application, any of these may be used. Among these, in the present application, the potential curing agent of a hot setting-type is preferably used, and the curing agent is subjected to a main curing process by being heated and pressed onto the busbar electrodes 11 and the back surface electrode 13. In the case when a liquid-state epoxy resin is used, a potential curing agent made of imidazoles, amines, sulfonium salts, onium salts, or the like, may be used.

As the silane coupling agent, epoxy-based, amino-based, mercapto-sulfide-based, or ureide-based agents may be used. Among these, in the present embodiment, an epoxy-based silane coupling agent is preferably used. Thus, it is possible to improve an adhesive property on an interface between the organic material and the inorganic material.

Moreover, as another additive composition, an inorganic filler is preferably contained. When the inorganic filler is contained therein, the flowability of a resin layer upon press-bonding can be adjusted so that the particle capturing rate can be improved. As the inorganic filler, materials, such as silica, talc, titanium oxide, calcium carbonate, magnesium oxide or the like, may be used, and the kind of the inorganic filler is not particularly limited.

Fig. 5 is a schematic view that shows one example of a product mode of the conductive adhesive film 17. The conductive adhesive film 17 is provided with a peeling base member 20 with a binder resin layer 18 laminated thereon, and these are molded into a tape shape. This tape-shaped conductive adhesive film 17 is wound around and stacked on a reel 21, with the peeling base member 20 being located on the peripheral side. As the peeling base member 20, not particularly limited, PET (Poly Ethylene Terephthalate), OPP (Oriented Polypropylene), PMP (Poly-4-methylpentene-1), PTFE (Polytetrafluoroethylene) or the like may be used.

The conductive adhesive film 17 has a structure in which the above-mentioned cathode collector tab wire 11 and the anode collector tab wire 15 are integrally stacked on the binder resin layer 18. More specifically, in the conductive adhesive film 17, the binder resin layer 18 is stacked on a copper ribbon foil with a wide width and laminated thereon, and this is further slit into a thin width by a slitter. Thus, the conductive adhesive film 17 with the peeling base member is stacked on the entire surface of one of the surfaces 11a, 15a of the cathode collector tab wire 11 and the anode collector tab wire 15. In this manner, by preliminarily stacking the cathode collector tab wire 11 and the anode collector tab wire 15 together with the conductive adhesive film 17 integrally into one unit, the peeling base member 20 is separated therefrom at the time of an actual use, and by bonding the binder resin layer 18 of the conductive adhesive film 17 onto the P-type electrode terminal unit 9 and the N-type electrode terminal unit 10, temporarily bonding processes between the cathode collector tab wire 11 as well as the anode collector tab wire 15 and the respective electrode terminal units 9, 10 are carried out.

The conductive adhesive film 17 is prepared by dissolving conductive particles 19, a film-forming resin, a liquid-state epoxy resin, a potential curing agent and a silane coupling agent into a solvent. As the solvent, toluene, ethyl acetate or the like, or a mixed solvent of these, may be used. A resin-forming solution obtained by the dissolving process is applied onto the peeling base member 20, and by evaporating the solvent, the conductive adhesive film 17 is obtained. Thereafter, as described earlier, the conductive adhesive film 17 is integrally stacked onto one surface 11a, 15a of each of the cathode collector tab wire 11 and the anode collector tab wire 15, and formed on the entire surface 11a, 15a of each of the cathode collector tab wire 11 and the anode collector tab wire 15.

The cathode collector tab wire 11 and the anode collector tab wire 15 are temporarily bonded to the P-type electrode terminal unit 9 and the N-type electrode terminal unit 10 with the conductive adhesive films 17 formed on the surfaces 11a, 15a being interposed therebetween. At this time, as will be described later, one end 24a of a terminal box tab wire 24 is temporarily disposed on the P-type electrode terminal unit 9 and the N-type electrode terminal unit 10 with the insulating adhesive layer 22 interposed therebetween.

Thereafter, in the thin-film solar cell 1, after the sealing agent sheet 3 and the back sheet 5 have been stacked thereon, the conductive adhesive film 17, the cathode collector tab wire 11, the anode collector tab wire 15 and the terminal box tab wire 24 are heated and pressed by a vacuum laminator, and connected thereon as one lot. At this time, the conductive adhesive film 17 is heated and processed by the vacuum laminator at predetermined temperature and pressure so that the binder resin is allowed to flow out between the P-type electrode terminal unit 9 and the cathode collector tab wire 11 as well as between the N-type electrode terminal unit 10 and the anode collector tab wire 15, with the conductive particles 19 being sandwiched between the respective collector tab wires 11, 15 and the respective electrode terminal units 9, 10; thus, the binder resin is cured in this state. Consequently, in the conductive adhesive film 17, the respective collector tab wires 11, 15 are bonded to the respective electrode terminal units 9, 10 so that the respective collector tab wires 11, 15 and the respective electrode terminal units 9, 10 are conductively connected to each other.

### [Modified Example]

Moreover, the conductive adhesive layer 16 is not necessarily required to be preliminarily bonded to the surfaces 11a, 15a of the cathode collector tab wire 11 and the anode collector tab wire 15. In this case, as the conductive adhesive layer 16, in addition to a film-state conductive adhesive film, a paste-state conductive adhesive paste may be used.

In the present application, the film-state conductive adhesive film 17 and the paste-state conductive adhesive paste containing the conductive particles 19 are defined as "conductive adhesive agent".

The conductive adhesive layer 16 thus prepared is cut into predetermined lengths in accordance with the P-type electrode terminal unit 9 and the N-type electrode terminal unit 10 upon joining the cathode collector tab wire 11 or the like of the conductive adhesive film 17, and preliminarily bonded onto the P-type electrode terminal unit 9 and the N-type electrode terminal unit 10 of the thin-film solar cell 1. Alternatively, as the conductive adhesive layer 16, the conductive adhesive paste is applied onto the P-type electrode terminal unit 9 and the N-type electrode terminal unit 10. Next, the cathode collector tab wire 11 and the anode collector tab wire 15, cut into predetermined lengths, are superposed and disposed onto the conductive adhesive layer 16, and heated and pressed so as to be conductively connected thereto.

### [Terminal Box]

Moreover, on the back surface electrode film of the thin-film solar cell 1, the terminal box 23, which electrically connects the cathode collector tab wire 11 and the anode collector tab wire 15 with each other through the terminal box tab wire 24, is installed. The terminal box 23 to which an external output line is electrically connected supplies power collected by the cathode collector tab wire 11 and the anode collector tab wire 15 to external devices.

The terminal box 23 is secured onto the back surface electrode film of the thin-film solar cell 1 through an insulating adhesive film 25 whose detailed description is omitted here. The insulating adhesive film 25, which is composed of virtually the same components as those of the conductive adhesive film 17 except that no conductive particles 19 are contained therein, allows the terminal box 23 to be secured onto the back surface electrode film of the thin-film solar cell 1 when the binder resin layer is thermally cured. Additionally, by mixing a chemically stable fluorine-based resin therein, the insulating adhesive film 25 is prevented from reacting with the back surface electrode film to cause corrosion, even when temporarily bonded onto the back surface electrode film of the thin-film solar cell 1.

Additionally, on the back surface electrode film of the thin-film solar cell 1, by installing the terminal box 23 at a position along a virtually middle portion in the width direction orthogonal to the longitudinal direction of the cathode collector tab wire 11 and the anode collector tab wire 15, the terminal box tab wire 24 having the same size can be used on the cathode collector tab wire 11 side as well as on the anode collector tab wire 15 side.

### [Terminal box Tab Wire]

The terminal box tab wire 24 that connects the terminal box 23 with the cathode collector tab wire 11 and the anode collector tab wire 15 is prepared as a flat rectangular-shaped wire formed by slitting a copper foil or an aluminum foil rolled into, for example, a thickness of 50 to 300µm, or by rolling a thin metal wire of copper, aluminum or the like into a flat plate shape, in the same manner as in the cathode collector tab wire 11 and the anode collector tab wire 15.

The terminal box tab wire 24 is formed on the back surface electrode film of the thin-film solar cell 1 with the insulating adhesive layer 22 interposed therebetween. By interposing the insulating adhesive layer 22 in the gap to the back surface electrode film of the thin-film solar cell 1, the terminal box tab wire 24 is prevented from causing short-circuits relative to the back surface electrode film of the thin-film solar cell 1.

As shown in Fig. 1, the insulating adhesive layer 22 is preliminarily formed over the entire surface of one surface of the terminal box tab wire 24 that is made in contact with the back surface electrode film of the thin-film solar cell 1, and is made of, for example, the insulating adhesive film 25. The insulating adhesive film 25 has the same composition as that of the conductive adhesive film 17 except that no conductive particles are contained in the binder resin layer.

In the insulating adhesive film 25 formed on the terminal box tab wire 24 also, by mixing a chemically stable fluorine-based resin therein, the insulating adhesive film 25 is prevented from reacting with the back surface electrode film to cause corrosion, even when temporarily bonded onto the back surface electrode film of the thin-film solar cell 1.

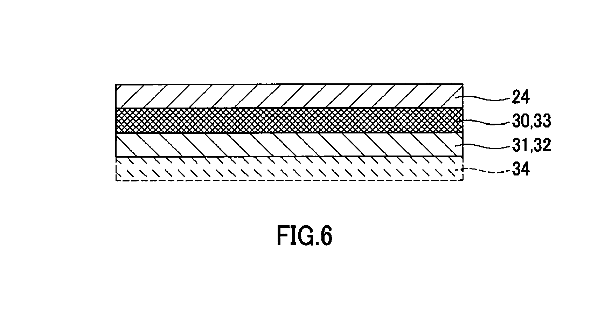

Moreover, in addition to the insulating film 25, the insulating adhesive layer 22 may be made of, for example, as shown in Fig. 6, a flexible substrate 31 with an insulating adhesive layer 30 or a film 33 with an insulating adhesive layer 32. In this case, each of the flexible substrate 31 and the film 33 has its insulating adhesive layer 30 and 32 formed at least on one surface thereof to which the terminal box tab wire 24 is connected. With respect to the flexible substrate 31 and the film 33, an adhesive layer 34 is optionally formed on the other surface that is made face to face with the back surface electrode film of the thin-film solar cell 1, or by using an Si-based adhesive as the adhesive layer 34 formed on the other surface, they may be lightly secured onto the back surface electrode film of the thin-film solar cell 1.

Additionally, the insulating adhesive layer 22, such as the insulating adhesive film 25 or the like, is preferably designed to have a width wider than the width of the terminal box tab wire 24. With this configuration, the insulating adhesive film 25 makes it possible to positively insulate the terminal box tab wire 24 from the back surface electrode film of the thin-film solar cell 1.

At least one pair of the terminal box tab wires 24 are formed on the back surface electrode film of the thin-film solar cell 1, and one of these connects the P-type electrode terminal unit 9 and the terminal box 23 with each other, and the other connects the N-type electrode terminal unit 10 and the terminal box 23 with each other.

Moreover, the terminal box tab wire 24 has its one end 24a disposed on the P-type electrode terminal unit 9 and the N-type electrode terminal unit 10, with the other end 24b being connected to the terminal box 23. Then, in the terminal box tab wire 24, the cathode collector tab wire 11 and the anode collector tab wire 15 are superposed on one end 24a with the conductive adhesive layer 16 interposed therebetween.

That is, as shown in Fig. 3, on the connection portion between the terminal box tab wire 24 and the cathode collector tab wire 11 or the anode collector tab wire 15, one end 24a of the terminal box tab wire 24 is connected onto the P-type electrode terminal unit 9 and the N-type electrode terminal unit 10, with the insulating adhesive layer 22, such as the insulating adhesive film 25 or the like, being interposed therebetween, and the cathode collector tab wire 11 or the anode collector tab wire 15 is connected to the side face and the upper surface of the one end 24a, with the conductive adhesive layer 16, such as the conductive adhesive film 17 or the like, interposed therebetween.

With this configuration, in the thin-film solar cell 1, the contact area between the terminal box tab wire 24 and the cathode collector tab wire 11 or the anode collector tab wire 15 through the conductive adhesive film 17 becomes larger in comparison with that of the configuration in which the terminal box tab wire is connected onto the collector tab wire, thereby improving the connection strength and preventing an increase of the resistance value.

Moreover, since the thin-film solar cell 1 is configured such that the connection between the terminal box tab wire 24 and the cathode collector tab wire 11 as well as the anode collector tab wire 15 is carried out as one lot by using a vacuum laminator, bubbles are prevented from entering the connection portion, thereby making it possible to improve the connection reliability for a long period of time. Additionally, in the case of an ultrasonic solder connection, there are risks such as a reduction of connection strength and an increase of connection resistance due to occurrence of voids or a reduction of connection reliability due to occurrence of cracks; however, these risks can be avoided in accordance with the thin-film solar cell 1.

### [Production Method]

Next, the following description will discuss the connection process between the cathode collector tab wire 11 as well as the anode collector tab wire 15 and the terminal box tab wire 24. First, a pair of the terminal box tab wires 24 are disposed on the back surface of the thin-film solar cell 1, with the insulating adhesive layer 22 interposed therebetween, and one end 24a of the terminal box tab wire 24 is disposed on the P-type electrode terminal unit 9 and the N-type electrode terminal unit 10, with the insulating adhesive layer 22 interposed therebetween.

These processes are carried out by temporarily bonding the terminal box tab wire 24 on which the insulating adhesive layer 22, such as the insulating adhesive film 25 or the like, is preliminarily formed on one surface thereof, onto the back surface electrode film of the thin-film solar cell 1, with its one end 24a being temporarily bonded onto the P-type electrode terminal unit 9 and the N-type electrode terminal unit 10. Moreover, these processes may be carried out by temporarily bonding the insulating adhesive film 25 along a connection portion of the terminal box tab wire 24 on the back surface electrode film of the thin-film solar cell 1, and then by temporarily bonding the terminal box tab wire 24 onto the insulating adhesive film 25.

The temporarily bonding processes of the terminal box tab wire 24 to which the insulating adhesive film 25 is pasted and of the insulating adhesive film 25 and the terminal box tab wire 24 are carried out by heating and pressing the insulating adhesive film 25 by a roll laminating process so as to allow it to exert viscosity to such a degree as not to be mainly cured. Moreover, the terminal box tab wire 24 has its insulating adhesive agent layer 22 separated from the other end 24b thereof by utilizing a blade or heat and made conductive, and is then connected to the terminal box 23.

Additionally, by forming the insulating adhesive layer 22 such as the insulating adhesive film 25 or the like so as to have a width larger than that of the terminal box tab wire 24, the insulating adhesive layer 22 is allowed to positively insulate the terminal box tab wire 24 from the back surface electrode film of the thin-film solar cell 1.

Next, the cathode collector tab wire 11 and the anode collector tab wire 15 are connected to the P-type electrode terminal unit 9 and the N-type electrode terminal unit 10 with the conductive adhesive layer 16 interposed therebetween, and one end 24a of the terminal box tab wire 24 is also connected onto the P-type electrode terminal unit 9 and the N-type electrode terminal unit 10 with the conductive adhesive layer 16 interposed therebetween.

These processes are carried out by temporarily bonding the cathode collector tab wire 11 and the anode collector tab wire 15, each having one surface on which the conductive adhesive layer 16 such as the conductive adhesive film 17 or the like is preliminarily formed, onto the P-type electrode terminal unit 9 and the N-type electrode terminal unit 10 as well as onto the one end 24a of the terminal box tab wire 24 disposed these electrode terminal units 9 and 10, with the conductive adhesive layer 16 being made face to face therewith. Moreover, these processes may be carried out by temporarily bonding the conductive adhesive film 17 onto the P-type electrode terminal unit 9 and the N-type electrode terminal unit 10 as well as onto the one end 24a of the terminal box tab wire 24 disposed on these electrode terminal units 9 and 10, and then by temporarily placing the cathode collector tab wire 11 or the anode collector tab wire 15 on the conductive adhesive film 17.

The temporarily placing processes of the collector tab wires 11, 15 with the conductive adhesive film 17 pasted thereto and of the conductive film 17 and the collector tab wires 11, 15 are carried out by heating and pressing the conductive adhesive film 17 by a roll laminating process so as to allow it to exert viscosity to such a degree as not to be mainly cured.

Thus, the cathode collector tab wire 11 and the anode collector tab wire 15 are temporarily placed in a manner so as to bridge over the one end 24a of the terminal box tab wire 24 with the conductive adhesive film 17 interposed therebetween.

The thin-film solar cell 1 on which the insulating adhesive film 25, the terminal box tab wire 24, the conductive adhesive film 17, the cathode collector tab wire 11 and the anode collector tab wire 15 are temporarily bonded in this manner is subjected to a laminating process as one lot by a vacuum laminator together with the sheet 3 of a translucent sealing material, such as EVA or the like, and the back sheet 5 formed on the back surface side.

At this time, since the thin-film solar cell 1 is heated and pressed at predetermined temperature and pressure, the insulating adhesive film 25 is thermally cured so that the terminal box tab wire 24 is connected to the back surface electrode film of the thin-film solar cell 1, with the one end 24a being connected onto the P-type electrode terminal unit 9 or the N-type electrode terminal unit 10. Moreover, the respective binder resins of the conductive adhesive film 17 are allowed to flow so that the conductive particles 19 are sandwiched between the cathode collector tab wire 11 and the P-type electrode terminal unit 9 as well as in a gap relative to the one end 24a of the terminal box tab wire 24 so that the binder resin is cured in this state. In the same manner, the conductive particles 19 are sandwiched between the anode collector tab wire 15 and the N-type electrode terminal unit 10 as well as in a gap relative to the one end 24a of the terminal box tab wire 24 so that the binder resin is cured in this state. Thus, the conductive adhesive film 17 allows the cathode collector tab wire 11 and the anode collector tab wire 15 to be bonded onto the P-type electrode terminal portion 9 and the N-type electrode terminal portion 10 so as to be conductively bonded to each other, and also allows the cathode collector tab wire 11 and the anode collector tab wire 15 to be bonded onto the terminal box tab wire 24.

In this manner, in accordance with the present technique, the terminal box tab wire 24, the cathode collector tab wire 11 and the anode collector tab wire 15 can be connected to one another efficiently. Moreover, in accordance with the present technique, it is not necessary to locally apply heating and pressing processes in comparison with processes in which the cathode collector tab wire 11 and the anode collector tab wire 15 are heated and pressed by using a hot pressing head or the like so as to be connected. Therefore, there is no fear of warping the translucent insulating substrate 10 and causing breakage thereto. In particular, as shown in Fig. 3, since a portion to which the one end 24a of the terminal box tab wire 24 is connected protrudes from the other portions, heat and stress tend to concentrate onto the connection portion of the terminal box tab wire 24 in the case when heating and pressing processes are applied by the hot pressing head or the like, with the result that warping and breakage occur in the transparent insulating substrate 8 and a connection failure occurs in the collector tab wire and the terminal box tab wire. Therefore, by using the one-lot laminate system, it is possible to effectively prevent warping and breakage in the translucent insulating substrate 8, or the like, by avoiding concentrations of heat and stress, and also to desirably carry out connecting processes among the collector tab wires 11, 15, the electrode terminal units 9, 10 and the terminal box tab wire 24.

The following description will discuss embodiments of a terminal box tab wire to which the present invention is applied. As sample 1, a tab wire made of an electrolytic copper foil having a width of 10 mm and a thickness of 35µm was used. As sample 2, a tab wire made of an electrolytic copper foil having a width of 10 mm and a thickness of 35µm on one side of which a PET film having a thickness of 25µm to 50µm was pasted as an insulating adhesive layer was used. As sample 3, a tab wire made of an electrolytic copper foil having a width of 10 mm and a thickness of 120µm on two surfaces of which solder plating processes were applied with a thickness of about 15µm was used. As sample 4, a tab wire made of an electrolytic copper foil having a width of 10 mm and a thickness of 150µm onto two surfaces of which solder plating processes were applied with a thickness of about 15µm was used.

As a collector tab wire, a tab wire made of an electrolytic copper foil having a thickness of 35µm and a width of 2.0 mm which was coated with a conductive adhesive resin was used. The coating surface of the conductive adhesive resin was subjected to a surface roughening treatment with a surface roughness of Rz : 7 to 9µm (GTS-MP: made by Furukawa Electric Co., Ltd.). Moreover, to the binder resin, 30 parts by weight ofNi particles (made by Vale Inco Japan Limited.) was added.

Each of the above-mentioned samples was temporarily bonded to a glass substrate with a sticker, while being heated to about 95°C, by using a roll laminating process, and a collector tab wire was then temporarily bonded to the glass substrate while being heated to about 95°C, by using the roll laminating process. At this time, the collector tab wire was made in contact with each sample in a manner so as to bridge over the sample with the conductive adhesive resin interposed therebetween.

Thereafter, the glass substrate was subjected to a vacuum laminating process by using a sealing resin (EVA), while being heated to about 160°C for 20 min, with a pressure of about 100 KPa being applied; thus, each of the samples was connected to the collector tab wire (connection area: 2.0 mm × 10 mm) so that four samples of connected members were prepared.

Each of the samples of connected members was measured for a connection resistance value, with a current of 1A being carried, and each of them had a value of 10mΩ or less. In other words, it was found that the connection between the collector tab wire and the terminal box tab wire, with the conductive adhesive resin interposed therebetween, is a method capable of replacing the conventional solder connection.

Moreover, in comparison with the ultrasonic solder connection, since no thermal pressing process is required at high temperature and high pressure locally caused by a solder fusing process, it is possible to prevent warping and breakage of the glass substrate. Furthermore, when the connection is carried out by a roll laminating process on the collector tab wire and the terminal box tab wire with a conductive adhesive resin interposed therebetween, it becomes possible to manufacture a thin-film solar cell by using a simple process.

### Reference Signs List

1...thin-film solar cell, 2...solar cell, 3...sheet, 5...black sheet, 6...solar cell module, 7...metal frame, 8...translucent insulating substrate, 9...P-type electrode terminal unit, 10...N-type electrode terminal unit, 11... cathode collector tab wire, 15...anode collector tab wire, 17...conductive adhesive film, 18...binder resin layer, 19...conductive particles, 20...peeling base member, 21...reel, 23...terminal box, 24...terminal box tab wire, 25...insulating adhesive film, 30...adhesive layer, 31...flexible substrate, 32...flexible substrate, 33...film

## Claims

1. A solar cell module comprising:
a solar cell with a cathode and an anode positioned on one surface thereof;
a pair of power extraction tab wires which are connected onto the cathode and the anode of the solar cell with a conductive adhesive layer containing conductive particles interposed therebetween; and
a pair of terminal box tab wires which are disposed on one surface of the solar cell with an insulating adhesive layer containing no conductive particles interposed therebetween, with one end thereof being positioned on the cathode and the anode, and which connect a terminal box with the pair of power extraction tab wires,
wherein the power extraction tab wires on the cathode and the anode are connected to the one end of the terminal box tab wires with the conductive adhesive layer interposed therebetween.

2. The solar cell module according to claim 1, wherein the pair of terminal box tab wires are disposed on the cathode or the anode, and the pair of power extraction tab wires are formed in a manner so as to bridge over the end portion of the terminal box tab wire.

3. The solar cell module according to claim 1 or 2, wherein the conductive particles are filament-shaped conductive particles.

4. The solar cell module according to any one of claims 1 to 3, wherein the power extraction tab wires and the terminal box tab wires are formed by a laminating process as one lot.

5. The solar cell module according to any one of claims 1 to 4, wherein the insulating adhesive layer is a film with an adhesive or a flexible substrate with an adhesive.

6. The solar cell module according to any one of claims 1 to 5, wherein the terminal box tab wire has a width narrower than the width of the insulating adhesive layer.

7. The solar cell module according to any one of claims 1 to 6, wherein the conductive adhesive layer contains a fluorine-based resin.

8. A method of manufacturing a solar cell module comprising the steps of:
preparing a solar cell with a cathode and an anode positioned on one surface thereof;
disposing a pair of terminal box tab wires with an insulating adhesive layer with no conductive particles contained therein interposed therebetween, as well as disposing end portions of the terminal box tab wires on the cathode and the anode with the insulating adhesive layer interposed therebetween; and
connecting a pair of power extraction tab wires onto the cathode and the anode of the solar cell with a conductive adhesive layer containing conductive particles interposed therebetween, as well as connecting the pair of power extraction tab wires to the end portions of the terminal box tab wires on the cathode and the anode, with the conductive adhesive layer interposed therebetween.

9. The method of manufacturing a solar cell module according to claim 8, further comprising the step of:
securing a terminal box on the one surface; and
connecting the end portions of the pair of terminal box tab wires to the terminal box.

10. The method of manufacturing a solar cell module according to claim 8 or 9, wherein the power extraction tab wires and the terminal box tab wires are formed by a laminating process as one lot.

11. The method of manufacturing a solar cell module according to any one of claims 8 to 10, wherein the conductive adhesive layer is preliminarily formed on the power extraction tab wires, and the insulating adhesive layer is preliminarily formed on the terminal box tab wires.
